# EUROPEAN PATENT APPLICATION

(11) **EP 4 664 695 A1**
(43) Date of publication of application: **17.12.2025**
(21) Application number: 24203212.6
(22) Date of filing: 27.09.2024
(51) Int. Cl.: H01S 5/42, H01S 5/042, H01S 5/02345, H01S 5/028

(54) **VERTICAL CAVITY SURFACE EMITTING LASERS ARRAY**

(30) Priority: 13.06.2024 US 202463659567 P; 26.06.2024 US 202418754604
(71) Applicant: II-VI Delaware, Inc., Wilmington, DE 19890 (US)
(72) Inventor: TAN, Jason, Wilmington, 19890 (US); STRZEBONSKI, Pawel, Wilmington, 19890 (US); LAURAIN, Alexandre, Wilmington, 19890 (US)
(74) Representative: Schmidt, Christian

(57) **Abstract**

This disclosure describes a device having a plurality vertical cavity surface emitting lasers (VCSELs) that are addressable in groups. The device has a bottom RDL that is able to electrically couple a first group of VCSELs to a first bond pad through to a bond pad via. The device also has a top RDL that is able to electrically couple a second group of VCSELs to a second bond pad through a group of VCSEL vias. Each VCSEL of the second group of VCSELs is electrically coupled to a corresponding VCSEL via of the group of VCSEL vias. Furthermore, the plurality of VCSEL may be positioned in any manner including randomly.

## Description

### CROSS REFERENCE TO RELATED APPLICATIONS

This application claims the benefit of and priority to U.S. Provisional Patent Application No. 63/659,567, titled "METHODS FOR AND SYSTEM OF VERTICAL CAVITY SURFACE EMITTING LASERS ARRAYS," filed June 13, 2024, the disclosure of which is incorporated herein by reference in its entirety.

### BACKGROUND

Limitations and disadvantages of traditional systems and methods for addressing vertical cavity surface emitting lasers (VCSELs) will become apparent to one of skill in the art, through comparison of such approaches with some aspects of the present method and system set forth in the remainder of this disclosure with reference to the drawings.

### BRIEF SUMMARY

Systems and methods are provided for addressing vertical cavity surface emitting lasers (VCSELs), substantially as illustrated by and/or described in connection with at least one of the figures, as set forth more completely in the claims.

### BRIEF DESCRIPTION OF THE DRAWINGS

FIG. 1 illustrates an example of an ohmic RDL in a system comprising independently addressable VCSELs, in accordance with various example implementations of this disclosure.
FIG. 2 illustrates an example of an insulation layer in a system comprising independently addressable VCSELs, in accordance with various example implementations of this disclosure.
FIG. 3 illustrates an example of a first address layer in a system comprising independently addressable VCSELs, in accordance with various example implementations of this disclosure.
FIG. 4 illustrates an example of a top RDL in a system comprising independently addressable VCSELs, in accordance with various example implementations of this disclosure.
FIG. 5 illustrates an example cross-section of a system comprising independently addressable VCSELs, in accordance with various example implementations of this disclosure.
FIG. 6 illustrates another example of a system comprising independently addressable VCSELs, in accordance with various example implementations of this disclosure.

### DETAILED DESCRIPTION

Vertical Cavity Surface Emitting Laser (VCSEL) arrays may be used for 3D sensing applications. This disclosure describes VCSEL array designs with multiple independent channels (or sub-arrays). VCSEL emitters of different channels may be intermixed and positioned at irregular (e.g., random or semi-random) locations.

Multi-channel regular arrays can be relatively simple in design and process, and so can single-channel irregular arrays. However, irregular arrays with multiple independent and intermixed channels tend to be complicated in design and/or process.

This disclosure provides a system and method for designing multi-channel arrays with intermixed and irregularly located emitters while retaining the relative simplicity in layout, processing, and design rules that multi-channel arrays with alternating row contacts enjoy.

Multi-channel VCSEL arrays may have sub-arrays of emitters that are physically separated from each-other, or else intermixed in the form of alternating row contacts. These alternating row contact designs generally place a row of emitters within the center of a row contact. As such, they tend to have regular emitter locations and the emitters are not fully intermixed.

Addressable VCSEL arrays may comprise arrays of emitters that are arranged in 1D (i.e., rows or columns), 2D or 3D configurations. The emitters in the arrays may be arranged such that emitters belonging to different channels are spatially separated and/or interleaved within an array location.

In the interleaved configuration, the emitters belonging to different arrays are connected via multi-layer redistribution layers (RDL), with one RDL assigned to one array channel. The RDL may be routed and overlaid to connect to the individual ohmic contact of the VCSEL, thereby resulting in the interleave pattern desired.

This disclosure describes a method for multi-channel, interleaved VCSEL arrays, where the ohmic RDL and the RDLs may be used in conjunction to connect the assigned emitters together. This minimizes the number of RDLs required, therefore simplifying the design and fabrication of the device.

Multi-channel VCSEL arrays with intermixed emitters and irregular emitter locations may use vertically stacked sheet contacts. While these solutions enable significant intermixing and irregularity in emitter locations, the processing and layout requirements tends to be more complicated to ensure effective isolation between the different channels, and there are concerns regarding the capacitance between the parallel sheet contacts (which may potentially limit the pulsing speed of these arrays), emitter power uniformity (as the lower sheet contact can have significantly different series resistances to different emitters), and dielectric breakdown (as the lower sheet contact introduces additional topology).

This disclosure is related to the design of individual vertical cavity surface emitting lasers (VCSELs) and the method by which they are positioned and electrically contacted in an array. Such VCSEL arrays may be used in 3D sensing, for example.

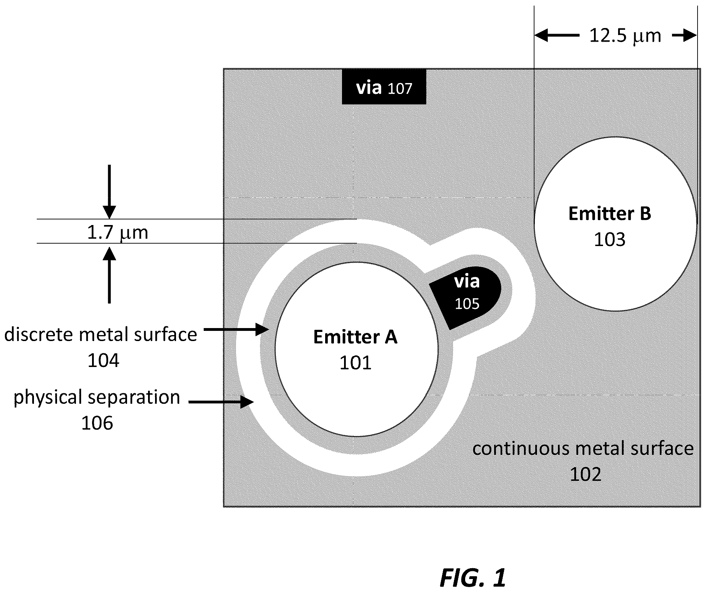

FIG. 1 illustrates an example of an ohmic RDL in a system comprising independently addressable VCSELs, in accordance with various example implementations of this disclosure.

The device of FIG. 1 comprises a plurality of VCSELs, the emitters 101 and 103 of each VCSEL are illustrated. Each VCSEL of the plurality of VCSELs comprises an emitter aperture that may have a diameter between, for example, 10 microns and 15 microns. Each VCSEL of the plurality of VCSELs may be operable to emit light (e.g., infrared light) of a specific wavelength (e.g., not more than 1000 nm).

The bottom/ohmic RDL in FIG. 1 comprises a first continuous metal surface 102 and one or more discrete metal surfaces 104. Each VCSEL of the plurality of VCSELs is connected to an ohmic contact metal 102 or 104 in the bottom RDL.

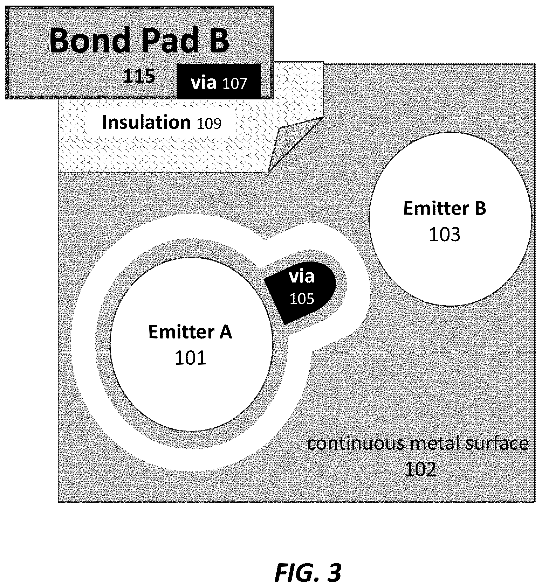

The first continuous metal surface 102 is able to electrically couple a first group of VCSELs (e.g., one VCSEL with an emitter 103) to a first bond pad (see 115 in FIGs. 3-5) through a first bond pad via 107. As illustrated, the first group of VCSELs (comprising Emitter B 103) form channel B.

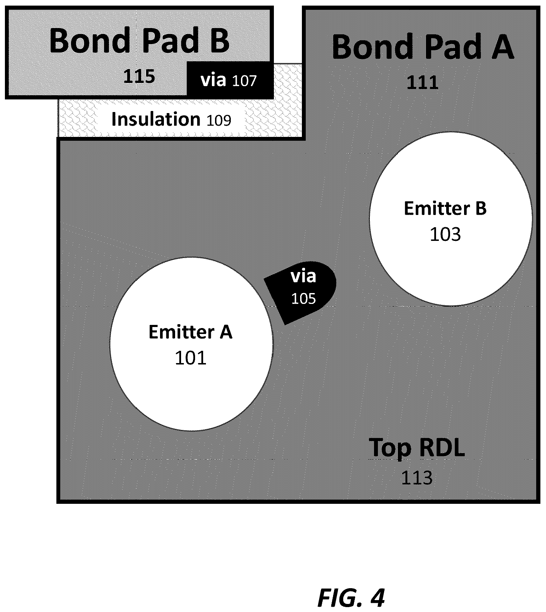

Each discrete metal surface 104 is able to electrically couple one VCSEL in the second group of VCSELs (e.g., one VCSEL with an emitter 101) to a second bond pad (see 111 in FIGs. 4-5) through a VCSEL via 105. As illustrated, the second group of VCSELs (comprising Emitter A 101) form channel A. Each VCSEL of the second group of VCSELs is connected to a different discrete metal surface 104 in the bottom RDL. Each different discrete metal surface 104 is coupled to a different VCSEL via 105. Each discrete metal surface 104, in the bottom RDL, is physically separated 106 from the first continuous metal surface 102. The physically separation may be between 1.5 microns and 2 microns.

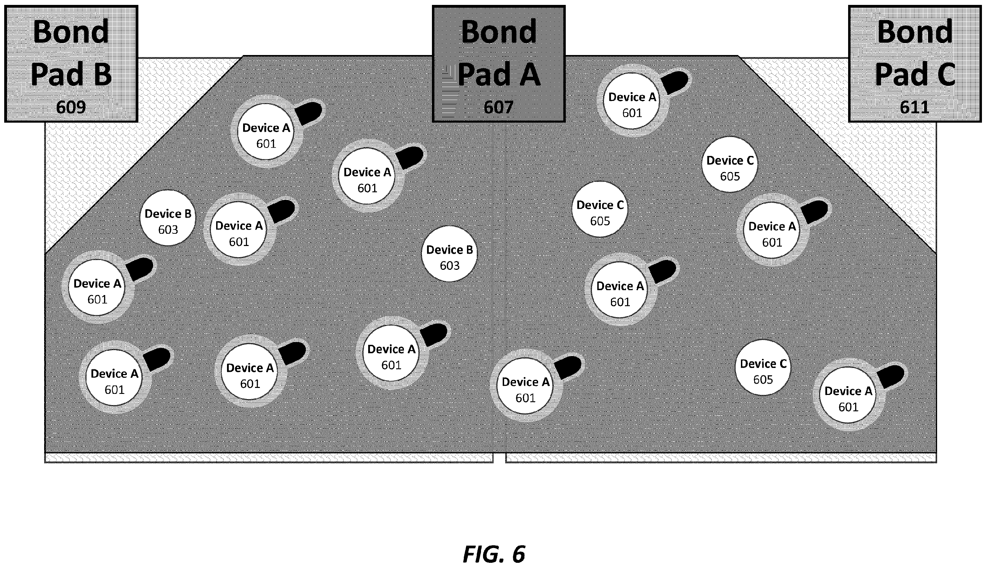

In various example implementations, the first group of VCSELs and the second group of VCSELs each comprise one or more VCSELs of a plurality of VCSELs. For illustration purposes, FIGs. 1-5 illustrate the first group of VCSELs and the second group of VCSELs as one VCSEL per group. FIG. 6 illustrates the first group of VCSELs and the second group of VCSELs as more than one VCSEL per group.

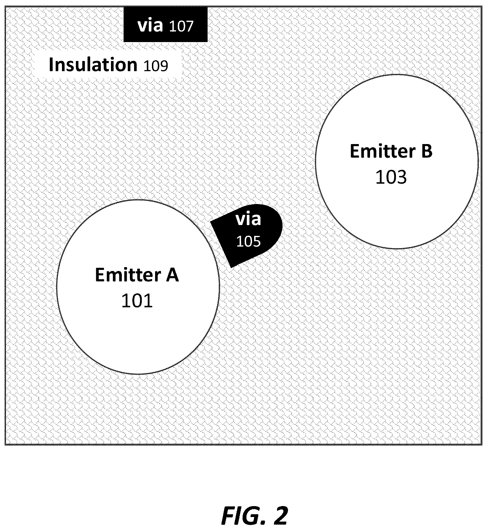

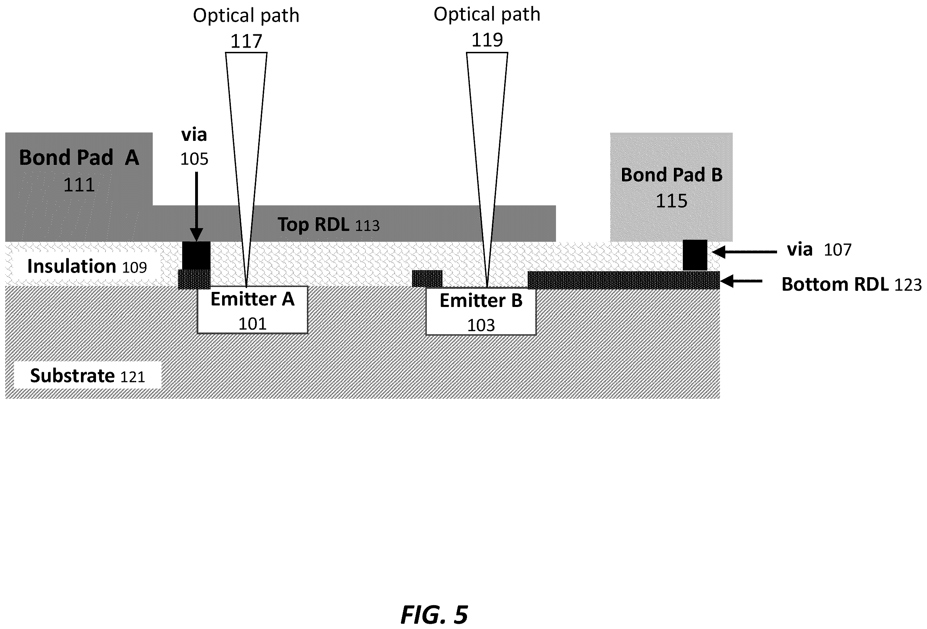

FIG. 2 illustrates an example of an insulation layer 109 in a system comprising independently addressable VCSELs 101 and 103, in accordance with various example implementations of this disclosure. The insulation layer 109 (comprising, e.g., SiO2 and or SiN) is able to electrically separate the bottom RDL (see 102 and 104 in FIG. 1) from a top RDL (see top RDL 113 in FIGS. 4 and 5). The group of VCSEL vias 105 and the first bond pad via 107 extend through the insulation layer 109.

FIG. 3 illustrates an example of a first address layer in a system comprising independently addressable VCSELs, in accordance with various example implementations of this disclosure. The first bond pad 115 is physically connected to (and on top of) the insulation layer 109 and electrically coupled to the first group of VCSELs (comprising Emitter B 103) through via 107 and the first continuous metal surface 102.

FIG. 4 illustrates an example of a top RDL 113 in a system comprising independently addressable VCSELs, in accordance with various example implementations of this disclosure.

The second bond pad (Bond Pad A 111) is physically connected to the top RDL 113. The top RDL 113 is operable to electrically couple a second group of VCSELs 101 to a second bond pad 111 through a group of VCSEL vias 105. The second group of VCSELs 101 comprises one or more VCSELs of the plurality of VCSELs. The first group of VCSELs 103 comprises different VCSELs than the second group of VCSELs 101. Each VCSEL of the second group 101 of VCSELs is electrically coupled to a corresponding VCSEL via 105 of the group of VCSEL vias.

FIG. 5 illustrates an example cross-section of a system comprising independently addressable VCSELs, in accordance with various example implementations of this disclosure.

The bottom RDL 123 comprises an ohmic contact metal dedicated and assigned to for connecting each emitter to the assigned channel of the emitter array. The RDLs are then connected to the bond pad 111 or 115 of the devices. An optical path 117 and 119 for each of the plurality of VCSELs 101 and 103 passes through an aperture.

Emitters A 101 and B 103 are connected to the bottom RDL 123. The bottom RDL 123 is connected directly to a bond pad 115 bypassing the top RDL 113. The bottom RDL 123 comprise the continuous metal surface 102 and the discrete metal surface(s) 104 as shown in FIG. 1.

This approach, whereby the bottom RDL 123 is used for addressability, reduces the number of RDL layers to achieve the interleave address VCSELs design, thereby simplifying the process flow.

FIG. 6 illustrates another example of a system comprising independently addressable VCSELs, in accordance with various example implementations of this disclosure.

The plurality of VCSELs in FIG. 6 comprise 3 channel groups. Channel A addresses the group of A devices 601 with bond pad A 607. Channel B addresses the group of B devices 603 with bond pad B 609. Channel C addresses the group of C devices 605 with bond pad C 611. All VCSELs within a particular channel (e.g., A, B or C) are simultaneously driven.

The group of B devices 603 and the group of C devices 605 are each coupled to a different continuous metal surface in the bottom RDL. As illustrated, the plurality of VCSELs are randomly positioned. Also, the number of VCSELs within each particular channel/group (e.g., A, B or C) may not need to be identical. For example, in some embodiments, the number of VCSELs in one group may be more than ten times the number of VCSELs in another group.

Implementations as described herein may relate to the following: a device having a plurality vertical cavity surface emitting lasers (VCSELs) that are addressable in groups. The device has a bottom RDL that is able to electrically couple a first group of VCSELs to a first bond pad through to a bond pad via. The device also has a top RDL that is able to electrically couple a second group of VCSELs to a second bond pad through a group of VCSEL vias. Each VCSEL of the second group of VCSELs is electrically coupled to a corresponding VCSEL via of the group of VCSEL vias. Furthermore, the plurality of VCSEL may be positioned in any manner including randomly.

The present application claims priority of U.S. Patent Application Nos. 63/659,567 filed June 13, 2024 and US 18/754,604 filed June 26, 2024. The entire disclosure of these applications is incorporated herein by reference for all purposes.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A device, comprising:
a plurality of vertical cavity surface emitting lasers (VCSELs);
a bottom redistribution layer (RDL) operable to electrically couple a first group of VCSELs to a first bond pad through a first bond pad via;
a top RDL operable to electrically couple a second group of VCSELs to a second bond pad through a group of VCSEL vias; and
an insulation layer operable to electrically separate the bottom RDL from the top RDL, wherein:
the first group of VCSELs comprises one or more VCSELs of the plurality of VCSELs,
the second group of VCSELs comprises one or more VCSELs of the plurality of VCSELs,
the first group of VCSELs comprises different VCSELs than the second group of VCSELs, and
each VCSEL of the second group of VCSELs is electrically coupled to a corresponding VCSEL via of the group of VCSEL vias.

2. The device of claim 1, wherein:
each VCSEL of the plurality of VCSELs comprises an emitter aperture with a diameter of less than 15 microns.

3. The device of claim 1 or 2, wherein:
each VCSEL of the plurality of VCSELs is operable to emit light in an infrared spectrum.

4. The device of any one of the preceding claims, wherein:
each VCSEL of the plurality of VCSELs is connected to an ohmic contact metal in the bottom RDL.

5. The device of any one of the preceding claims, wherein:
each VCSEL of the first group of VCSELs is connected to a first continuous metal surface in the bottom RDL.

6. The device of claim 5, wherein:
the first continuous metal surface is electrically coupled to the first bond pad via.

7. The device of claim 5 or 6, wherein:
each VCSEL of the second group of VCSELs is connected to a discrete metal surface in the bottom RDL.

8. The device of claim 7, wherein:
each discrete metal surface, connected to each VCSEL of the second group of VCSELs, is electrically coupled to the corresponding VCSEL via.

9. The device of claim 7 or 8, wherein:
each discrete metal surface, in the bottom RDL, is physically separated from the first continuous metal surface.

10. The device of claim 8 or 9, wherein:
the physically separation is between 1.5 microns and 2 microns.

11. The device of any one of the preceding claims, wherein:
the group of VCSEL vias and the first bond pad via extend through the insulation layer.

12. The device of any one of the preceding claims, wherein:
the first bond pad is physically connected to the insulation layer.

13. The device of any one of the preceding claims, wherein:
the second bond pad is physically connected to the top RDL.

14. The device of any one of the preceding claims, wherein:
an optical path for each of the plurality of VCSELs passes through the insulation layer and the top RDL.

15. The device of any one of the preceding claims, wherein:
the bottom RDL is operable to electrically couple a third group of VCSELs to a third bond pad through a second bond pad via.

16. The device of claim 15, wherein:
each VCSEL of the third group of VCSELs is connected to a second continuous metal surface in the bottom RDL.

17. The device of claim 16, wherein:
the second continuous metal surface is electrically coupled to the second bond pad via.

18. The device of any one of the preceding claims, wherein:
the plurality of VCSELs are randomly positioned.

19. The device of any one of the preceding claims, wherein:
the second group of VCSELs comprises more than ten times a number of VCSELs of the first group of VCSELs.
